# EUROPEAN PATENT SPECIFICATION

(11) **EP 2 126 635 B1**
(45) Date of publication and mention of the grant of the patent: **18.04.2012**
(21) Application number: 08707189.0
(22) Date of filing: 22.01.2008
(51) Int. Cl.: G03F 7/20

(54) **METHOD FOR IMPROVING IMAGING PROPERTIES OF AN OPTICAL SYSTEM, AND OPTICAL SYSTEM**
VERFAHREN ZUR VERBESSERUNG VON BILDGEBUNGSEIGENSCHAFTEN EINES OPTISCHEN SYSTEMS UND OPTISCHES SYSTEM
PROCÉDÉ POUR AMÉLIORER LES PROPRIÉTÉS DE FORMATION D'IMAGE D'UN SYSTÈME OPTIQUE ET SYSTÈME OPTIQUE CORRESPONDANT

(30) Priority: 22.01.2007 DE 102007004723
(43) Date of publication of application: 02.12.2009
(73) Proprietor: Carl Zeiss SMT GmbH, 73447 Oberkochen (DE)
(72) Inventor: CONRADI, Olaf, 73463 Westhausen/Westerhofen (DE)
(74) Representative: Carl Zeiss AG - Patentabteilung
(86) International application number: PCT/EP2008/000459
(87) International publication number: WO 2008/089953

(56) References cited:
- EP-A- 0 678 768
- EP-A- 1 376 092
- WO-A-2007/017089
- US-A1- 2006 146 662
- US-A1- 2006 244 940

## Description

The invention relates to a method for improving imaging properties of an optical system.

The invention furthermore relates to an optical system having improved imaging properties.

Optical systems are used e.g. in the form of projection objectives in semiconductor lithography for fabricating finely patterned components. In the present description, reference is made in particular to a projection objective of this type.

Optical systems of this type have a plurality of optical elements, which can be formed e.g. as lenses, mirrors or plane-parallel plates having a wide variety of reflection/refraction properties.

A projection objective is used to image a structure or a pattern of a mask (reticle) onto a light-sensitive substrate. In this case, the structure arranged in the object plane of the optical system is illuminated by an illumination source and its associated illumination optical assembly. The light transmitted through the structure is directed through the optical system and exposes the light-sensitive substrate arranged in the image plane of the optical system.

The structures to be imaged on the substrate are being made smaller and smaller nowadays in order to increase the integration density of the structures in ever shrinking components. Therefore, there is an increased requirement imposed on optical systems to improve their imaging properties and their resolution capability such that their imaging quality is increased.

The imaging quality of an optical system is governed by imaging aberrations occurring in the optical system, such as e.g. areas resulting from aberrations. Such imaging aberrations can be thermally induced during the operation of the optical system by at least one optical element of the optical system being heated and altering the imaging properties of the optical system.

Owing to the heating of the at least one optical element, an irreversible, radiation-dictated alteration of the material of the at least one optical element can occur. By way of example, an alteration of the density of the material (compaction) leads to a local change in the refractive index of the optical element. Furthermore, it is possible that a temporary, reversible alteration of the material of the optical element in the form of a change in refractive index or else a geometrical deformation can occur and influences the imaging properties of the optical system.

Depending on the illumination mode of the optical system, the heating of the at least one optical element can be rotationally symmetrical or non-rotationally symmetrical relative to the optical axis of the optical system. Non-rotationally symmetrical heating is brought about e.g. by dipole illumination produced by a mask or a grating in the illumination optical assembly.

It is known that thermally induced imaging aberrations can be at least partly corrected by means of a deformation of the optical elements. In general, such deformations produce specific wavinesses (azimuthal periodicities) in the wavefront profiles of the optical elements, with which corresponding waviriesses of wavefront aberration profiles are at least partly corrected. Waviness (azimuthal periodicity) of wavefronts should be understood to mean the integral multiple of an angle to 2 π, whereby the wavefront merges into itself again after its azimuthal rotation about the pupil midpoint.

It is known from WO 99/67683 that a lens arranged in a mount in an optical system can be mechanically deformed by means of a manipulator. In this case, the manipulator has one or more actuators that act on the lens approximately perpendicular to the optical axis and produce on it non-rotationally symmetrical forces deviating from the radial. On account of the lens distortion established, it is possible to induce an imaging aberration that compensates for an imaging aberration of the overall system, such that imaging aberrations of the optical system are minimized in a targeted manner.

However, it has been found in everyday practice with mechanical manipulators that only simple, i.e. low-order wavefront aberration profiles can be corrected by deformation of the optical element. If the optical element has a complicated wavefront aberration profile, it is necessary for the optical element to be deformed in a higher-order manner. Such a deformation can be realized mechanically only in a very complicated fashion. Furthermore, both in the optical element and between the optical element and its mount, mechanical stresses occur which can damage the optical element and its mount. This greatly restricts the scope of use of mechanical manipulators for correcting imaging aberrations.

EP 0 678 768 B1 discloses a projection exposure apparatus comprising a plurality of optical elements. The optical elements are assigned thermal manipulators arranged in a manner distributed peripherally at the optical elements. The thermal manipulators counteract a non-rotationally symmetrical temperature distribution, which reduces the imaging capability of the projection exposure apparatus, by cooling or heating partial regions of the optical elements. On account of the change in temperature of the optical elements, their material properties such as, for example, their coefficients of thermal expansion and their refractive index and their geometry change. Furthermore, it is possible to reduce imaging aberrations by positioning, i.e. displacing, tilting and/or rotating the optical elements.

Furthermore, US 6,198,579 B1 discloses an optical system in which at least one lens is assigned a plurality of thermal manipulators. The manipulators are arranged in a manner distributed peripherally at the lens and are designed to alter the temperature distribution and the geometry of the lens by cooling or heating said lens. Imaging aberrations of the optical element can be at least partly corrected by this means. The manipulators are formed as Peltier elements.

One disadvantage of thermal manipulators is that the optimum thermally governed deformation of the optical elements only occurs in delayed fashion. This is based on the fact that the desired temperature distribution must first be set in the optical elements by heating/cooling the optical elements. From everyday experience in dealing with optical elements that are to be deformed thermally, it is known that the time between the start-up of the thermal manipulators and the desired deformation of the optical elements can amount to a number of minutes, for instance up to ten minutes. As a result, considerable delays can occur in the use of the optical system.

A further disadvantage of thermal manipulators for correcting imaging aberrations results from a change - to be calculated in a complicated manner - in the imaging properties of an optical element on account of the induced temperature change. If optical elements are deformed in temperature-dictated fashion, the imaging properties of the optical elements, for example the refractive index, likewise change with the temperature. In order to achieve a best possible correction of the imaging aberrations, the temperature-dictated deformation of the optical elements must consequently be considered and controlled very precisely.

US 2006/0244940 A1 discloses a projection objective for microlithography, comprising mechanical as well as thermal manipulators. The thermal manipulator consists of an arrangement of infrared light emitters which heat one of the optical elements such that a non-rotationally symmetrical temperature distribution is transferred into a rotationally symmetrical temperature distribution. The mechanical manipulator which positions one or several optical elements by means of a mechanical force action is employed to correct rotationally symmetrical imaging aberrations which remain after the thermal correction.

Further, US 2006/014662 A1 discloses an optical immersion system in which optical elements are mechanically and thermally deformed for correcting aberrations.

There is still a need for a method for improving imaging properties of an optical system with which imaging aberrations of the optical system can be effectively reduced in a short time.

Therefore, it is an object of the present invention to provide such a method.

It is furthermore an object of the present invention to provide an optical system which is improved with regard to the imaging properties.

According to the invention, the object is achieved by means of a method for improving imaging properties of an optical system according to claim 1.

Furthermore, the object is achieved according to the invention by means of an optical system having improved imaging properties according to claim 10.

The method according to the invention and the optical system according to the invention improve the imaging properties of the optical system by virtue of at least a first optical element accommodated in the optical system being positioned and/or deformed by means of a mechanical force action and a thermal action. As an alternative, it is provided that the at least first optical element is positioned and/or deformed by means of mechanical force action and at least a second optical element accommodated in the optical system is deformed by means of thermal action. The mechanical force actions and the thermal actions are produced by means of mechanical and thermal manipulators, respectively.

The mechanical positioning and/or deformation and the thermal deformation of the at least first and/or at least second optical element leads to a changed wavefront profile of the optical system, such that at least one imaging aberration can be at least partly corrected by this means.

According to the invention, a mechanical/thermal deformation of an optical element should be understood to mean an optical alteration of its properties, in particular of its geometry and/or of its material properties, such as e.g. refractive index, coefficient of thermal expansion or the like.

A mechanical positioning of an optical element is to be understood as a displacement along or transverse the optical axis, a rotation about the optical axis and/or a tilt. The optical elements can be formed e.g. as lenses, mirrors or plane-parallel plates having a wide variety of refraction and reflection properties.

Positioning and/or deformation of optical elements by means of mechanical force action and deformation by means of thermal action advantageously results in two different possibilities for correcting basic orders and higher orders of imaging aberrations of the optical system. Both ways of deforming or positioning an optical element are sufficiently known and can be used in a well controllable and targeted manner for correcting wavefront aberration profiles of the optical system.

A further advantage is based on the fact that a thermal deformation of an optical element can be used when a mechanical deformation would lead to damage to the optical element or its mount. The thermal deformation of the optical element thus enables a correction of imaging aberrations which would not be permitted by a simple mechanical deformation.

Furthermore, simultaneously performed mechanical positioning and/or deformationand thermal deformation of optical elements reduces the time required for a correction of imaging aberrations.

According to the invention, the at least first optical element is positioned and/or deformed by means of mechanical force action and deformed by means of thermal action in temporally superposed fashion or the at least first optical element is positioned and/or deformed by means of mechanical force action and, in temporally superposed fashion, the at least second optical element is deformed by means of thermal action.

This measure has the advantage that complicated wavefront aberration profiles of the optical system can be optimally corrected in the interaction of a mechanically and a thermally induced manipulation of an optical element.

The at least first optical element may be positioned and/or deformed by means of a temporally constant mechanical force action.

This measure has the advantage that the mechanical force action can be provided in a simple and readily controllable manner. The correction effect of a temporally constant mechanical force action on optical elements is sufficiently known and can therefore be predicted well. Furthermore, the technical requirements imposed on mechanical manipulators which produce a temporally constant mechanical force action are less stringent than in the case of those manipulators which produce a temporally variable mechanical force action.

The at least first optical element and/or the at least second optical element may be deformed by means of a temporally variable thermal action, for example by means of a temporally linearly rising thermal action.

This measure has the advantage that the thermal action can be optimally adapted to the temporally variable wavefront aberration profiles of the optical system. The imaging aberrations of the optical system can be corrected particularly well by this means.

In a preferred configuration, the mechanical force action for positioning and/or deforming the first optical element is adjusted and/or varied in a time duration of less than 1 sec., preferably of less than 500 msec., further preferably of less than 100 msec.

In the optical system, the at least one mechanical manipulator is assigned a controller which actuates the mechanical manipulator in a time duration of less than 1 sec., preferably of less than 500 msec., further preferably of less than 100 msec. for adjusting and/or varying the mechanical force action. After each of such time durations, the manipulator is in a rest state.

The at least one mechanical manipulator is, thus, triggered for a minimum time duration only, in order to adjust the desired force action, e.g. in order to position and/or deforming the first optical element, and just thereafter, the actuation of the mechanical manipulator is interrupted so that an adjusted mechanical force action is reached. This adjusted mechanical force action is constant and may have a value of greater than zero or approximately equal to zero. These short-time actuations of the mechanical manipulator have the advantage that oscillations or vibrations generated by the actuation of the mechanical manipulator can decay before the optical system, in particular in case of a projection objective for microlithography, is used for exposing a substrate. The substrate, also referred to as a wafer, is divided into a plurality of single areas also referred to as "die". Each die is usually separately exposed one after the other. The afore-mentioned measure assures that the oscillations generated by the actuation of the mechanical manipulator are decayed before a die exposure is commenced.

In a further preferred configuration, the mechanical force action for positioning and/or deforming the first optical element is adapted in time intervals Δt_{mech}.

This configuration represents the case of an adjustment and/or variation of the mechanical force action on the first optical element in time intervals. The time intervals Δt_{mech} are preferably adapted to the time intervals of the exposure of the single dies.

In other words, the mechanical manipulator is triggered die by die, in order to adapt the position and/or deformation of the first optical element to the imaging correction required due to the heating of the optical elements of the system.

In the optical system, the afore-mentioned controller actuates the at least one mechanical manipulator in time intervals Δt_{mech}, accordingly. The time intervals Δt_{mech} of the triggering or actuation of the mechanical manipulator are, thus, greater than the time duration of the actuation itself, and are, in the average, in the range of 1 to 5 sec., for example, corresponding to the time interval of the single exposure of each single die.

In another preferred configuration, the thermal action on the first and/or second optical element is carried out continuously.

Differently from the mechanical manipulator, a thermal manipulator is not subject to the problem of oscillations and vibrations. The thermal manipulator, therefore, can be actuated continuously, in order to shorten thermal time constants.

But even in case of the thermal manipulator it can be preferred if the thermal action on the first and/or second optical element can be carried out in time intervals Δtₜₕₑᵣₘ.

In the optical system, the at least one thermal manipulator is also assigned a controller, accordingly, which actuates the thermal manipulator continuously or in time intervals Δtₜₕₑᵣₘ.

Preferably, the time intervals Δtₜₕₑᵣₘ and Δt_{mech} of the actuation of the mechanical force action and the thermal action are selected such that the ratio Δtₜₑᵣₘ/Δt_{mech} is in the range from 0 to about 10. The value 0 means a continuous actuation of the thermal manipulator, a value of about 1 means an actuation of the mechanical manipulator and the thermal manipulator in equal time intervals, for example die by die, and a value of larger than 1, for example 7 to 10, means that the thermal manipulator is actuated for the time duration of a complete wafer exposure, i.e. the actuation of the thermal manipulator is not interrupted after each single exposure of a single die, while this is still the case for the mechanical manipulator.

The thermal action may be carried out in such a way that it produces a rotationally symmetrical temperature distribution in the at least first optical element and/or in the at least second optical element.

This measure has the advantage that imaging aberrations of the optical system which are based on a rotationally symmetrical heating of the optical elements are corrected on account of the rotationally symmetrical temperature distribution established in the optical elements.

The thermal action may be carried out in such a way that it produces a non-rotationally symmetrical temperature distribution in the at least first optical element and/or in the at least second optical element.

This measure has the advantage that imaging aberrations which are based on a non-rotationally symmetrical heating of the optical elements, such as are produced e.g. by illumination poles, can be corrected by means of a non-rotationally symmetrical temperature distribution induced in the optical elements.

The thermal action may be carried out in such a way that it produces a temperature change in an edge region of the at least first optical element and/or of the at least second optical element.

This measure has the advantage that the temperature change is provided in the optically unused region of the optical elements. Proceeding from the edge regions, the induced temperature change can expand in the entire optical elements.

The mechanical force action may be carried out in such a way that it extends a range of effect of the thermal action.

This measure has the advantage that a greater deformation is achieved in contrast to an only mechanically induced or only thermally induced deformation of the optical element.

In a further preferred configuration, the mechanical force action and the thermal action are carried out in such a way that they minimize a time period between an actual and desired correction of the at least one imaging aberration.

This measure has the advantage that the at least partial correction of the at least one imaging aberration is effected rapidly. This advantageously reduces maintenance times during the operation of the optical system.

In a further preferred configuration, the at least one imaging aberration is determined before the at least partial correction of the at least one imaging aberration.

This measure has the advantage that the imaging aberration can be optimally improved based on the knowledge of said imaging aberration.

The at least one imaging aberration may be determined by direct measurement of a wavefront profile.

This measure has the advantage that the imaging aberration can be determined in a simple manner without further technical outlay.

In a further preferred configuration, the at least one imaging aberration is determined by estimation of a field- and diffraction-angle-dependent light distribution in the optical system.

This measure has the advantage that this provides a further method for determining the at least one imaging aberration which can be carried out in a simple manner. The estimation of the light distribution in the optical system uses a knowledge of layer and volume absorption coefficients of the optical elements. The intensity absorbed in the optical elements and the temperature distribution of the optical elements are determined on the basis of the mode of illumination of the structure by the illumination source and illumination optical assembly. The coefficients of thermal expansion and the refractive indices of the optical elements can be calculated therefrom in order to deduce the wavefront aberration profile of the optical system.

In a further preferred configuration, the at least one imaging aberration is determined by comparison of the field- and diffraction-angle-dependent light distribution in the optical system with the field- and diffraction-angle-dependent light distribution of reference measurements.

This measure has the advantage of providing yet another possibility for determining the imaging aberrations which can be performed in a simple manner. Since the imaging aberrations of the reference light distributions are known, the at least one imaging aberration of the optical system can be deduced directly.

In a further preferred configuration, the at least one imaging aberration is determined by measurement of the field- and diffraction-angle-dependent light distribution in at least one plane of the optical system by means of a detector.

This measure provides yet another possibility for determining the imaging aberrations of the optical system which can be carried out in a simple manner. The measurement of the light distribution is preferably carried before a substrate exposure, wherein a detector, such as e.g. a CCD camera, is used. The light distribution can be measured e.g. in a plane of the optical system which is a plane near the pupil, a plane near the field and/or an intermediate plane.

A temporal development of the at least one imaging aberration may be detected after the at least one imaging aberration has been determined and before the at least partial correction of the at least one imaging aberration is carried out.

This measure enables the imaging aberration to be optimally corrected on the basis of the knowledge of the imaging aberrations occurring in the future.

A knowledge of the at least one imaging aberration may be used to determine the temporal development of the at least one imaging aberration.

This measure has the advantage that the future temporal development of the imaging aberration can be predicted very precisely based on the present imaging aberration. Furthermore, it is possible in addition to take account of imaging aberrations that have already occurred at earlier points in time in the prediction of the temporal development of the at least one imaging aberration such that the temporal development can be predicted even more precisely.

The best possible correction that can be achieved may be determined for at least partly correcting the at least one imaging aberration.

This measure enables the imaging aberration to be optimally corrected with the inclusion of all possible corrections that can be carried out.

In the case of the optical system according to the invention, in accordance with the preferred configurations of the optical system which are specified in the claims, it is possible to apply the above-described method for improving the imaging properties of the optical system.

Further advantages and features will become apparent from the following description and the accompanying drawing.

It goes without saying that the features mentioned above and those yet to be explained below can be used not only in the combinations specified, but also in other combinations or by themselves, without departing from the scope of the present invention.

The invention is explained and described in more detail below on the basis of some selected exemplary embodiments in association with the accompanying drawing, in which:
- Fig. 1: shows a schematic illustration of an optical system during an exposure of a substrate;
- Fig. 2: shows a schematic illustration of an at least partial correction of at least one imaging aberration; and
- Fig. 3: shows a flowchart of a method according to the invention for improving imaging properties of the optical system.

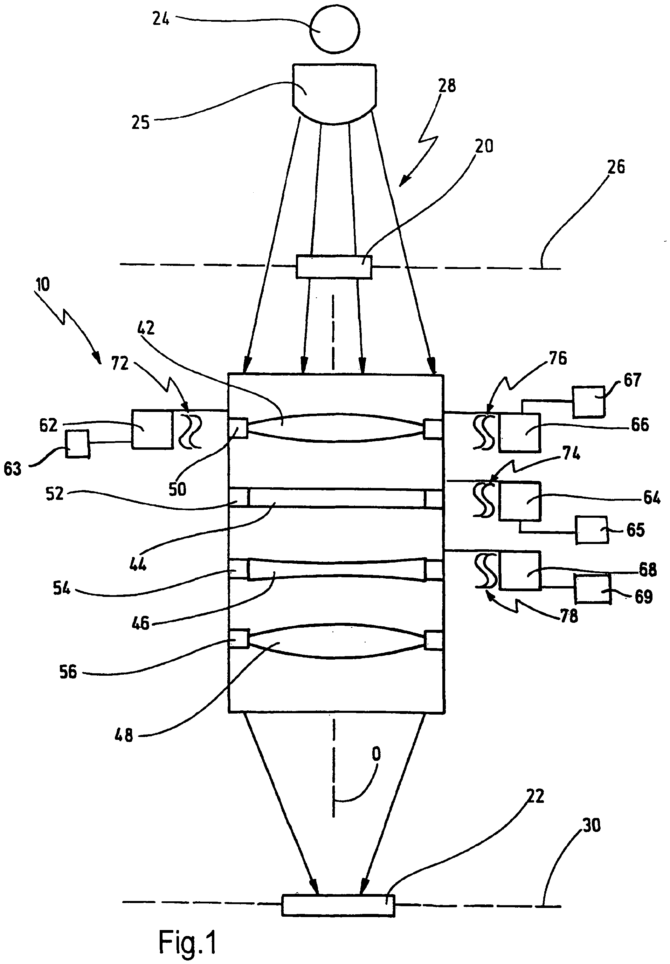

Fig. 1 illustrates an optical system, which is provided with the general reference symbol 10 and which permits an imaging of a structure 20 or a pattern of a mask (reticle) onto a light-sensitive substrate 22.

An optical system 10 of this type can be used as a projection objective for fabricating finely patterned components in microlithography.

An illumination source 24, which is assigned an illumination optical assembly 25, illuminates the structure 20 arranged in an object plane 26 of the optical system 10. Light beams 28 are transmitted through partial regions of the structure 20 and impinge on the optical system 10. The optical system 10 images the structure 20 in demagnified fashion onto the light-sensitive substrate 22 arranged in an image plane 30 of the optical system 10.

The optical system 10 has a plurality of optical elements, in the schematic illustration four optical elements 42-48, which can be formed as lenses, mirrors or plane-parallel plates having a wide variety of refraction and reflection properties. Each optical element 42-48 is accommodated in a respective mount 50-56 in the optical system 10.

During the operation of the optical system 10, at least one imaging aberration can occur as a result of heating of one or more optical elements 42-48. Owing to the heating, material properties of the optical elements 42-48 can change irreversibly in a manner dictated by radiation. By way of example, the density of the optical elements 42-48 can change (compaction, rarefaction), such that refractive indices or coefficients of thermal expansion of the optical elements 42-48 are altered as a result. Furthermore, the heating of the optical elements 42-48 can lead to a temporary alteration of geometry and material properties.

The heating of the optical elements 42-48 can occur rotationally symmetrically or non-rotationally symmetrically relative to an optical axis O of the optical system 10. Instances of non-rotationally symmetrical heating are brought about e.g. by a mask or a grating in the illumination optical assembly 25, wherein illumination poles for the optical system can be produced thereby.

The method according to the invention serves for improving the imaging properties of the optical system 10 by correcting at least one imaging aberration of the optical system 10.

For this purpose, the optical system 10 has a plurality of manipulators, in the schematic illustration four manipulators 62-68, which are assigned to the plurality of optical elements. The manipulators 62-68 can be formed as mechanical manipulators 62-64 or as thermal manipulators 66-68.

By way of example, an optical element 42 can be assigned at least one mechanical manipulator 62 and at least one thermal manipulator 66. Furthermore, it is possible for in each case at least one mechanical manipulator 64 or at least one thermal manipulator 68 to be assigned to a respective optical element 44, 46 and to act on the optical element 44, 46.

The manipulators 62-68 serve for at least partly correcting at least one imaging aberration of the optical system 10. Each mechanical manipulator 62, 64 can have one more actuators that act on the optical element 42, 44 and produce a mechanical force action 72, 74 on the optical element 42, 44. The optical element 42, 44 is thereby positioned or mechanically deformed, wherein in case of a deformation it is altered optically with regard to its properties, in particular its geometry and/or its material properties such as e.g. the refractive index or the like. A positioning of the optical element 42, 44 does not result in an alteration of the geometry or the material properties of the optical element 42, 44, but a positioning here means a displacement of the optical element 42, 44 in direction or transverse the direction of the optical axis O, a rotation of the optical element 42, 44 about the optical axis O and/or a tilt of the optical element 42, 44 about an axis perpendicular to the optical axis O.

The mechanical force action 72, 74 can act at any desired regions of the optical element 42, 44. Furthermore, it commences immediately after the start-up of the mechanical manipulators 62, 64 and acts, after actuation, in temporally constant fashion, wherein the mechanical force action then can have a value of greater than zero or approximately equal to zero.

The mechanical manipulators 62, 64 can comprise actuators for a deformable lens element in order to correct imaging aberrations having a waviness in 2^{nd} order, or actuators for positioning the optical element 42, 44.

The mechanical manipulators 62, 64 are actuated for a short time duration only, in order to adjust and/or vary the desired mechanical force action. This time duration is in the range of less than about 1 sec., preferably of less than 500 msec., further preferably of less than 100 msec. This time duration is sufficient, because the mechanical manipulator 62, 64 acts instantaneously, i.e. its time constants for adjusting and/or varying the desired mechanical force action are minimal.

The mechanical manipulators 62, 64 are preferably actuated or triggered whenever the exposure of the substrate 22 is just interrupted. The substrate 22, also referred to as wafer, is, on its surface to be exposed, divided into a plurality of dies to be exposed one after the other, and the mechanical manipulators 62, 64 are preferably triggered at the time when the exposure of one die is completed and before the exposure of the next die commences. The mechanical manipulators 62, 64 are, thus, triggered in time intervals Δt_{mech}, in order to adjust and/or vary the respective desired mechanical force action on the optical element 42, 44, wherein these time intervals preferably correspond to the time intervals of the exposure between subsequent dies. The time intervals Δt_{mech} can be in the range of 1 to 5 sec., and can be, for example, about two secs.

In an example, the mechanical manipulators 62, 64 are assigned controllers 63, 65 which control the actuation of the mechanical manipulators 62, 64 in a timed manner. The controllers 63, 65 actuate the manipulators 62, 654 in time intervals Δt_{mech} for a short time duration only as described before.

The thermal manipulators 66, 68 produce a thermal action 76, 78 on the optical element 42, 46. The optical element 42, 46 is thereby thermally deformed by heating/cooling of its partial regions. According to the invention, a thermally induced deformation of the optical element 42, 46 should be understood to mean a temperature-dictated alteration of its properties, in particular the change in its geometry and/or its material properties such as e.g. its coefficient of thermal expansion and its refractive index.

The thermal manipulators 66, 68 can be formed as heating wires, Peltier elements or in accordance with the principle of a heat pump. The thermal manipulators 66, 68 can be designed in such a way that they induce a temperature distribution of the optical elements 42, 46 that is to be produced can be supplied by sources and sinks.

The thermal manipulators 66, 68 are also assigned controllers 67, 69.

Furthermore each manipulator 62-68 can be driven individually in each case. It is likewise possible for all the manipulators 62-68 to be driven jointly or in different combinations with one another.

The mechanical 62 and the thermal manipulator 66 are used in temporally superposed fashion, such that the mechanical force action 72 and the thermal action 76 act on the optical element 42 in temporally superposed fashion. It is likewise possible for the mechanical manipulator 64 and the thermal manipulator 68, which are assigned to the different optical elements 44, 46, to be used in temporally superposed fashion, such that the mechanical force action 74 and the thermal action 78 act simultaneously on the optical elements 44, 46. Consequently, a mechanical positioning and/or deformation and a thermally induced deformation of the respective optical elements 42-46 occurs simultaneously and changes the imaging properties of said optical elements. This extends a region of effect of the thermal manipulators 66, 68, since a region of effect of the mechanical manipulators 62, 64 is added to the region of effect of the thermal manipulators 66, 68.

The thermal manipulators 66, 68 can be triggered by the controller 67, 69 in a continuous manner or in time intervals Δtₜₕₑᵣₘ which can approximately correspond to the time intervals Δt_{mech}, or which can be larger than Δt_{mech} by a factor of about 10. In general, the thermal manipulators 66, 68 and the mechanical manipulators 62, 64 are triggered in time intervals Δt_{mech} and Δtₜₕₑᵣₘ such that the ratio Δtₜₕₑᵣₘ/Δt_{mech} is in the range from 0 to about 10, wherein the value 0 means a continuous triggering of the thermal manipulators 66, 68. A value of Δtₜₕₑᵣₘ/Δt_{mech} ≈1 means a triggering of the thermal manipulator 66, 68 in the time intervals of the single die exposures which are carried out one after the other, and a value of this ratio of larger than 1 and up to about 10 means an actuation of the thermal manipulator 66, 68 for the time duration of the complete exposure of the substrate 22, i.e. an actuation of the thermal manipulator 66, 68 wafer by wafer.

If the mechanical manipulators 62, 64 and the thermal manipulators 66, 68 simultaneously act on the optical elements 42-48, then a time period between an actual and a desired correction 84 of the at least one imaging aberration is reduced. The mechanically induced positioning and/or deformation of the optical elements 42, 44 is added to the thermally induced deformation of the optical elements 42, 46, such that the obtainable required deformation of the optical elements 42, 46 can be smaller and is achieved more rapidly in contrast to a sole effect of the thermal manipulators 66,68.

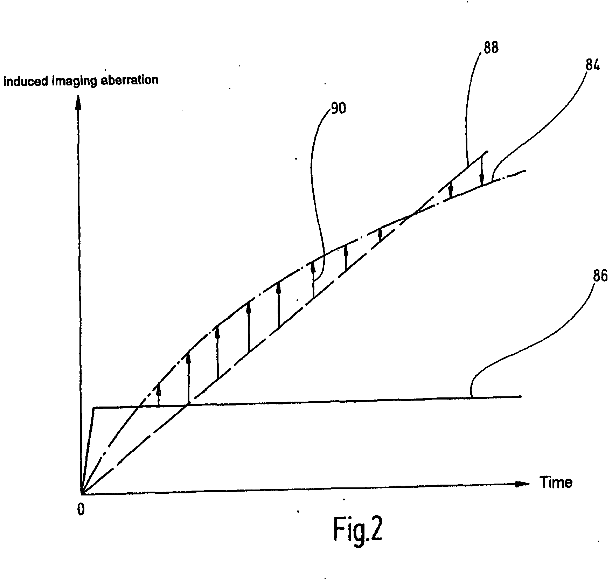

Fig. 2 shows an example of a temporal profile of the at least partial correction of the at least one imaging aberration of the optical system 10, wherein an imaging aberration induced by mechanical manipulators 62, 64 or thermal manipulators 66, 68 is plotted against time. The induced imaging aberration at least partly compensates for the at least one imaging aberration of the optical system 10.

The intended desired correction 84 of the at least one imaging aberration of the optical system 10 is obtained by a correction 86 and a correction 88. The correction 86 results from the positioning and/or deformation of the optical elements 42, 44 by means of the mechanical manipulators 62, 64. The correction 88 results from the deformation of the optical elements 42, 46 by means of the thermal manipulators 66, 68.

The correction 86 commences immediately after the start-up of the mechanical manipulators 62, 64, and it is temporally constant, until the mechanical manipulators are triggered again. The correction 88 of the at least one imaging aberration increases linearly with time. The desired correction 84 results from the corrections 86, 88 combined with one another, which is indicated by arrows 90.

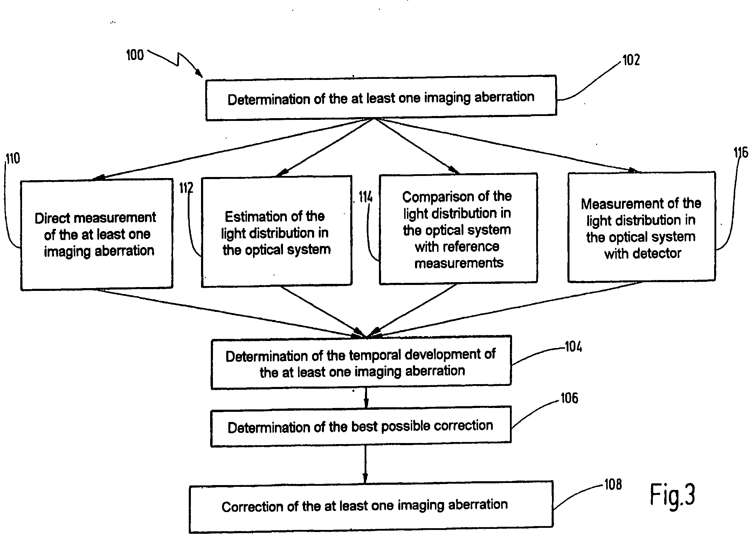

The at least partial correction of the at least one imaging aberration is carried out during a method 100 for improving imaging properties of an optical system 10 (see Fig. 3). The method 100 has the method steps 102-108, a determination of the at least one imaging aberration, a determination of a temporal development of the at least one imaging aberration, a determination of a best possible correction and an at least partial correction of the at least one imaging aberration.

The individual method steps 102-108 of the method 100 can be carried out in each case individually or in different combinations with one another.

The method step 102, the determination of the at least one imaging aberration, can be carried out by means of substeps 110-116, wherein the latter can also be used in combination. The substep 110 is based on a direct measurement of the at least one imaging aberration. For this purpose, it is possible to use a wavefront detector such as is illustrated e.g. in EP 1 231 517 A1, US 5 978 085 A1, US 5 392 119 A1 or US 5 828 455 A1.

Furthermore, by means of the substep 112, the field- and diffraction-angle-dependent light distribution in the optical system 10 can be estimated on the basis of the mode of illumination of the structure 20 by the illumination source 24 and the illumination optical assembly 25. In this case, the intensity absorbed in the optical elements 42-48, that is to say the temperature distribution thereof, is determined by means of a knowledge of layer and volume absorption coefficients of the optical elements 42-48. The resulting coefficients of thermal expansion or the resulting temperature-dependent change in refractive index of the optical elements 42-48 and the effects thereof on the overall wavefront of the optical system 10 can thus be calculated. The substep 114 for determining imaging aberrations is effected by means of a comparison of the field- and diffraction-angle-dependent light distribution in the optical system with a field- and diffraction-angle-dependent light distribution of reference measurements.

Furthermore, the method step 102 for determining imaging aberrations can be carried out by means of the substep 116, the measurement of a light distribution in one or more planes of the optical system 10 e.g. before a substrate exposure. In one preferred configuration, the measurement of the light distribution is carried out by means of a detector, e.g. a CCD camera. In accordance with the substep 112, the imaging aberrations of the optical system 10 can be deduced by means of the measured light distribution. The measurement of the light distribution can be performed near the pupil and/or near the field and/or at intermediate positions of the optical system 10.

After the method step 102, the determination of the at least one imagining aberration, the method step 104, the calculation of the temporal development of the at least one imaging aberration, is carried out. This method step 104 can include a knowledge of the at least one imaging aberration at preceding points in time. Preferably, the temporal development of the at least one imaging aberration can be calculated up to a few hours in advance.

The method step 106, the calculation of the best possible correction of the at least one imaging aberration of the optical system 10, takes account of a duration for which the at least one imaging aberration of the optical system 10 is intended to be at least partly corrected. In this case, the optimum correction that can be achieved can be carried out by means of the optimization of a quadratic norm of different imaging aberrations at different points in time, the optimization of an integral value at different points in time, such as e.g. of the rms value of the wavefront, or by means of an optimization of corresponding maximum norms.

The method step 108, the at least partial correction of the at least one imaging aberration, can be carried out, as explained above, by means of a mechanical force action 72, 74 and a thermal action 76-78.

## Claims

1. A method for improving imaging properties of an optical system (10), wherein the optical system (10) has a plurality of optical elements, wherein, for at least partly correcting at least one imaging aberration, at least a first optical element (42) from the plurality of optical elements is positioned and/or deformed by means of mechanical force action (72) and by means of thermal action (76) in temporally superposed fashion, or the at least first optical element (42) is positioned and/or deformed by means of mechanical force action (72) and, in temporally superposed fashion, at least a second optical element (46) from the plurality of optical elements is deformed by means of thermal action (78).

2. The method of Claim 1, wherein the mechanical force action for positioning and/or deforming the at least one optical element (42) is adjusted and/or varied in a time duration of less than I sec., preferably of less than 500 msec., further preferably of less than 100 msec.

3. The method of anyone of Claims I through 2, wherein the mechanical force action for positioning and/or deforming the first optical element (42) is adapted in time intervals Δt_{mech}.

4. The method of anyone of Claims 1 through 3, wherein the thermal action on the first and/or second optical element (42, 46) is carried out continuously.

5. The method of anyone of Claims 1 through 4, wherein the thermal action on the first and/or the second optical element (42, 46) is actuated in time intervals Δtₜₕₑᵣₘ.

6. The method of Claim 3 and of Claim 5, wherein Δtₜₕₑᵣₘ/Δt_{mech} is in the range from 0 to about 10.

7. The method of Claim 1, wherein the at least one imaging aberration is determined before the at least partial correction of the at least one imaging aberration and by estimation of a field- and diffraction-angle-dependent light distribution in the optical system (10).

8. The method of Claim 7, wherein the at least one imaging aberration is determined by comparison of the field- and diffraction-angle-dependent light distribution in the optical system (10) with the field- and diffraction-angle-dependent light distribution of reference measurements.

9. The method of anyone of Claims 7 through 8, wherein the at least one imaging aberration is determined by measurement of the field- and diffraction-angle-dependent light distribution in at least one plane of the optical system (10) by means of a detector.

10. An optical system having improved imaging properties, wherein the optical system (10) has a plurality of optical elements, wherein the plurality of optical elements are assigned a plurality of manipulators for actively positioning and/or deforming the plurality of optical elements, wherein at least one first manipulator (62, 64) from the plurality of manipulators is formed as a mechanical manipulator and at least one second manipulator (66, 68) from the plurality of manipulators is formed as a thermal manipulator, **characterized in that** the mechanical (62, 64) and the thermal manipulator (66, 68) are designed in
such a way that they can be used for at least partly correcting at least one imaging aberration in temporally superposed fashion

11. The optical system of Claim 10, wherein the at least one mechanical manipulator (62, 64) is assigned a controller (63, 65) which actuates the mechanical manipulator (62, 64) in a time duration of less than I sec., preferably of less than 500 msec., further preferably of less than 100 msec., for adjusting and/or varying the mechanical force action.

12. The optical system of anyone of Claims 10 through 11, wherein the controller (63, 65) actuates the mechanical manipulator (62, 64) in time intervals Δt_{mech}.

13. The optical system of anyone of Claims 10 through 12, wherein the at least one thermal manipulator (66, 68) is assigned a controller (67, 69) which actuates the thermal manipulator (66, 68) continuously or in time intervals Δtₜₕₑᵣₘ.

14. The optical system of Claim 12 and of Claim 13, wherein the actuation of the mechanical manipulator (62, 64) and of the thermal manipulator (66, 68) is such that Δtₜₕₑᵣₘ/Δt_{mech} is in the range from 0 to about 10.

15. The optical system of anyone of Claims 10 through 14, wherein a time period between an actual and desired correction (84) of the at least one imaging aberration can be minimized by the temporally superposed use of the mechanical (62, 64) and thermal manipulator (66, 68).

## Patentansprüche

1. Verfahren zur Verbesserung von Bildgebungseigenschaften eines optischen Systems (10), wobei das optische System (10) mehrere optische Elemente aufweist, wobei für das zumindest teilweise Korrigieren mindestens einer Bildgebungsaberration mindestens ein erstes optisches Element (42) von den mehreren optischen Elementen mit Hilfe mechanischer Kraftwirkung (72) und mit Hilfe thermischer Wirkung (76) auf zeitlich überlagerte Weise positioniert und/oder verformt wird oder das mindestens erste optische Element (42) mit Hilfe mechanischer Kraftwirkung (72) positioniert und/oder verformt wird und auf zeitlich überlagerte Weise mindestens ein zweites optisches Element (46) von den mehreren optischen Elementen mit Hilfe thermischer Wirkung (78) verformt wird.

2. Verfahren nach Anspruch 1, wobei die mechanische Kraftwirkung zum Positionieren und/oder Verformen des mindestens einen optischen Elements (42) in einer Zeitdauer von weniger als 1 s, bevorzugt weniger als 500 ms, weiter bevorzugt weniger als 100 ms, eingestellt und/oder variiert wird.

3. Verfahren nach einem der Ansprüche 1 bis 2, wobei die mechanische Kraftwirkung zum Positionieren und/oder Verformen des ersten optischen Elements (42) in Zeitintervallen Δt_{mech} angepasst wird.

4. Verfahren nach einem der Ansprüche 1 bis 3, wobei die thermische Wirkung auf das erste und/oder zweite optische Element (42, 46) kontinuierlich durchgeführt wird.

5. Verfahren nach einem der Ansprüche 1 bis 4, wobei die thermische Wirkung auf das erste und/oder das zweite optische Element (42, 46) in Zeitintervallen Δtₜₕₑᵣₘ aktiviert wird.

6. Verfahren nach Anspruch 3 und Anspruch 5, wobei Δtₜₕₑᵣₘ/Δt_{mech} im Bereich von 0 bis etwa 10 liegt.

7. Verfahren nach Anspruch 1, wobei die mindestens eine Bildgebungsaberration vor der mindestens teilweisen Korrektur der mindestens einen Bildgebungsaberration und durch Schätzen einer feld- und diffraktionswinkelabhängigen Lichtverteilung auf dem optischen System (10) bestimmt wird.

8. Verfahren nach Anspruch 7, wobei die mindestens eine Bildgebungsaberration durch Vergleich der feld- und diffraktionswinkelabhängigen Lichtverteilung in dem optischen System (10) mit der feld-und diffraktionswinkelabhängigen Lichtverteilung von Referenzmessungen bestimmt wird.

9. Verfahren nach einem der Ansprüche 7 bis 8, wobei die mindestens eine Bildgebungsaberration durch Messung der feld- und diffraktionswinkelabhängigen Lichtverteilung in mindestens einer Ebene des optischen Systems (10) mit Hilfe eines Detektors bestimmt wird.

10. Optisches System mit verbesserten Bildgebungseigenschaften, wobei das optische System (10) mehrere optische Elemente aufweist, wobei die mehreren optischen Elemente mehreren Manipulatoren zum aktiven Positionieren und/oder Verformen der mehreren optischen Elemente zugewiesen sind, wobei mindestens ein erster Manipulator (62, 64) von den mehreren Manipulatoren als ein mechanischer Manipulator ausgebildet ist und mindestens ein zweiter Manipulator (66, 68) von den mehreren Manipulatoren als ein thermischer Manipulator ausgebildet ist, **dadurch gekennzeichnet, dass** der mechanische (62, 64) und der thermische Manipulator (66, 68) derart ausgelegt sind, dass sie zumindest für das teilweise Korrigieren mindestens einer Bildgebungsaberration auf zeitlich überlagerte Weise verwendet werden können.

11. Optisches System nach Anspruch 10, wobei der mindestens eine mechanische Manipulator (62, 64) einem Controller (63, 65) zugewiesen ist, der den mechanischen Manipulator (62, 64) in einer Zeitdauer von weniger als 1 s, bevorzugt weniger als 500 ms, besonders bevorzugt weniger als 100 ms, aktiviert, um die mechanische Kraftwirkung einzustellen und/oder zu variieren.

12. Optisches System nach einem der Ansprüche 10 bis 11, wobei der Controller (63, 65) den mechanischen Manipulator (62, 64) in Zeitintervallen Δt_{mech} aktiviert.

13. Optisches System nach einem der Ansprüche 10 bis 12, wobei der mindestens eine thermische Manipulator (66, 68) einem Controller (67, 69) zugewiesen ist, der den thermischen Manipulator (66, 68) kontinuierlich oder in Zeitintervallen Δtₜₕₑᵣₘ aktiviert.

14. Optisches System nach Anspruch 12 und Anspruch 13, wobei die Aktivierung des mechanischen Manipulators (62, 64) und des thermischen Manipulators (66, 68) derart ist, dass Δtₜₕₑᵣₘ/Δt_{mech} im Bereich von 0 bis etwa 10 liegt.

15. Optisches System nach einem der Ansprüche 10 bis 14, wobei eine Zeitperiode zwischen einer tatsächlichen und gewünschten Korrektur (84) der mindestens einen Bildgebungsaberration durch die zeitlich überlagerte Verwendung des mechanischen (62, 64) und thermischen Manipulators (66, 68) minimiert werden kann.

## Revendications

1. Procédé pour améliorer les propriétés de formation d'image d'un système optique (10), dans lequel le système optique (10) comporte une pluralité d'éléments optiques, dans lequel, pour au moins partiellement corriger au moins une aberration de formation d'image, au moins un premier élément optique (42) parmi la pluralité d'éléments optiques est positionné et/ou déformé au moyen d'une action de force mécanique (72) et au moyen d'une action thermique (76) de façon temporellement superposée, ou l'au moins un premier élément optique (42) est positionné et/ou déformé au moyen d'une action de force mécanique (72) et, de façon temporellement superposée, au moins un second élément optique (46) parmi la pluralité d'éléments optiques est déformé au moyen d'une action thermique (78).

2. Procédé selon la revendication 1, dans lequel l'action de force mécanique destinée au positionnement et/ou à la déformation de l'au moins un élément optique (42) est ajustée et/ou amenée à varier pendant un intervalle de temps inférieur à 1 s, de préférence inférieur à 500 ms, de préférence encore inférieur à 100 ms.

3. Procédé selon l'une quelconque des revendications 1 à 2, dans lequel l'action de force mécanique destinée au positionnement et/ou à la déformation du premier élément optique (42) est adaptée au cours d'intervalles de temps Δt_{mech}.

4. Procédé selon l'une quelconque des revendications 1 à 3, dans lequel l'action thermique sur le premier et/ou le second élément optique (42, 46) est effectuée en continu.

5. Procédé selon l'une quelconque des revendications 1 à 4, dans lequel l'action thermique sur le premier et/ou le second élément optique (42, 46) est activée au cours d'intervalles de temps Δtₜₕₑᵣₘ.

6. Procédé selon la revendication 3 et selon la revendication 5, dans lequel Δtₜₕₑᵣₘ/Δt_{mech} est dans la gamme de 0 à environ 10.

7. Procédé selon la revendication 1, dans lequel l'au moins une aberration de formation d'image est déterminée avant la correction au moins partielle de l'au moins une aberration de formation d'image et par estimation d'une distribution de lumière dépendant du champ et de l'angle de diffraction dans le système optique (10).

8. Procédé selon la revendication 7, dans lequel l'au moins une aberration de formation d'image est déterminée par comparaison de la distribution de lumière dépendant de l'angle de champ et de diffraction dans le système optique (10) à la distribution de lumière dépendant de l'angle de champ et de diffraction de mesures de référence.

9. Procédé selon l'une quelconque des revendications 7 à 8, dans lequel l'au moins une aberration de formation d'image est déterminée par mesure de la distribution de lumière dépendant de l'angle de champ et de diffraction dans au moins un plan du système optique (10) au moyen d'un détecteur.

10. Système optique ayant des propriétés améliorées de formation d'image, dans lequel le système optique (10) comporte une pluralité d'éléments optiques, dans lequel à la pluralité d'éléments optiques sont affectés une pluralité de manipulateurs destinés à positionner et/ou à déformer activement la pluralité d'éléments optiques, dans lequel au moins un premier manipulateur (62, 64) parmi la pluralité de manipulateurs est réalisé sous la forme d'un manipulateur mécanique et au moins un second manipulateur (66, 68) parmi la pluralité de manipulateurs est réalisé sous la forme d'un manipulateur thermique, **caractérisé en ce que** le manipulateur mécanique (62, 64) et le manipulateur thermique (66, 68) sont conçus de manière à ce qu'ils puissent être utilisés pour corriger au moins partiellement au moins une aberration de formation d'image de façon temporellement superposée.

11. Système optique selon la revendication 10, dans lequel à au moins un manipulateur mécanique (62, 64) est affecté un dispositif de commande (63, 65) qui actionne le manipulateur mécanique (62,64) pendant un intervalle de temps inférieur à 1 s, de préférence inférieur à 500 ms, de préférence encore inférieur à 100 ms, pour ajuster et/ou faire varier l'action de force mécanique.

12. Système optique selon l'une quelconque des revendications 10 à 11, dans lequel le dispositif de commande (63, 65) actionne le manipulateur mécanique (62,64) au cours d'intervalles de temps Δt_{mech}.

13. Système optique selon l'une quelconque des revendications 10 à 12, dans lequel à l'au moins un manipulateur thermique (66, 68) est affecté un dispositif de commande (67, 69) qui actionne le manipulateur thermique (66, 68) en continu ou au cours d'intervalles de temps Δtₜₕₑᵣₘ.

14. Système optique selon la revendication 12 et selon la revendication 13, dans lequel l'actionnement du manipulateur mécanique (62, 64) et du manipulateur thermique (66, 68) est tel que Δtₜₕₑᵣₘ/Δt_{mech} est dans la gamme de 0 à environ 10.

15. Système optique selon l'une quelconque des revendications 10 à 14, dans lequel une période de temps comprise entre des corrections effective et souhaitée (84) de l'au moins une aberration de formation d'image peut être minimisée par l'utilisation temporellement superposée des manipulateurs mécanique (62, 64) et thermique (66, 68).
